# EUROPEAN PATENT APPLICATION

(11) **EP 2 337 438 A1**
(43) Date of publication of application: **22.06.2011**
(21) Application number: 09179233.3
(22) Date of filing: 15.12.2009
(51) Int. Cl.: H05K 9/00

(54) **Electromagnetic pulse protection for an enclosed construction**

(71) Applicant: SIEMENS AKTIENGESELLSCHAFT, 80333 München (DE)
(72) Inventor: Will, Emanuel, 96146, Altendorf (DE)

(57) **Abstract**

The present invention provides a method and an arrangement for protection for an enclosed construction from an electromagnetic pulse. The proposed method (S10) comprises installing (S11) a plurality of electrically insulative supporting structures (13, 13A-B, 13C-D) on a surface (11) of said construction. The method then involves installing (S12) one or more pieces of an electromagnetic pulse screening fabric (14) made of an electrically conductive material, by fastening each of said one or more pieces of said fabric (14) to one or more of said supporting structures (13, 13A-B, 13C-D), said one or more pieces of said fabric (14) being installed so as to form a continuous electrically conductive layer around said construction that is impenetrable for an electromagnetic pulse.

## Description

The present invention relates to protection of an enclosed construction from the action of external electromagnetic influences such as an electromagnetic pulse (EMP) attack. Such an EMP may comprise, for example high-altitude electromagnetic pulse (HEMP) and high power electromagnetic (HPEM) pulse, among others.

An electromagnetic pulse (EMP) is a burst of electromagnetic radiation from an explosion (especially a nuclear explosion) or a suddenly fluctuating magnetic field. The resulting electric and magnetic fields may couple with electrical/electronic systems to produce damaging current and voltage surges. EMP includes, for example, high-altitude electromagnetic pulse (HEMP) and high power electromagnetic (HPEM) pulse, among others.

A Faraday cage, named after the English scientist Michael Faraday who invented the same, is known to be an enclosure formed by conducting material that blocks out external static electrical fields and electromagnetic radiation. The operation of a Faraday cage depends on the fact that an external static electrical field will cause the electrical charges within the conducting material of the cage to redistribute themselves so as to cancel the field's effects in the cage's interior. This phenomenon is used, for example, to protect electrical and electronic equipment from lightning strikes and other electrostatic discharges.

However, there is no known technique for protection of an entire industrial or civil construction from an EMP attack.

The object of the present invention is to provide a technical solution for protection of an entire construction (such as an industrial or a civil construction) from an electromagnetic pulse.

The above object is achieved by the method according to claim 1 and the arrangement according claim 13.

The underlying idea of the present invention is to protect an entire enclosed construction from an EMP pulse based on the principle of the "Faraday cage" using an EMP screening fabric made of an electrically conductive material. To that end, electrically insulative supporting or carrier structures are first installed on to a surface of the construction and the EMP screening fabric is then fastened on to the supporting structures. The proposed installation ensures that all electrical connections are closed. The present invention may be advantageously used for EMP protection of civil and industrial constructions and other constructions where safety from EMP attacks is critical.

In one embodiment, to facilitate installation of the supporting structures, said installing of said supporting structures further comprises fixing a plurality of anchoring structures on to said surface of said construction and securely fastening each supporting to one or more of said plurality of anchoring structures.

In one exemplary embodiment, said anchoring structures comprise dowels and said supporting structures comprise metallic cables having respective electrically insulative outer sheaths, wherein installing each of said cables comprises anchoring the ends of that cable tautly between a pair of said dowels.

In an alternate exemplary embodiment, said anchoring structures comprise electrically insulative clamping structures bolted on to said surface and said supporting structures comprise electrically insulative pipes, wherein installing each of said pipes comprises clamping that pipe to one or more of said clamping structures.

In one embodiment, said fastening of each of said one or more pieces of electromagnetic pulse screening fabric comprises clamping said piece to said one or more supporting structures. This eliminates the need to use of any embedding materials on the EMP fabric for support.

In one exemplary embodiment, the proposed method comprises installing a layer of protective fabric over said layer of said electromagnetic pulse screening fabric. This reduces mechanical damages to the EMP fabric.

In an alternate embodiment, for enhanced protection, the proposed method comprises installing two layers of said electrically conductive electromagnetic pulse screening fabric separated by an intermediate electrically insulative layer of fabric and fastened on to said supporting structures.

In a further embodiment, the proposed method further includes, installing a reinforcement structure fixed electrically insulatingly to said electromagnetic pulse screening fabric. This embodiment is particularly advantageous for providing mechanical protection in case of installations in contact with the soil.

In a still further embodiment, the proposed method further includes installing one or more damping plates fixed electrically insulatingly to said reinforcement. Again, this embodiment is particularly advantageous in cases of installations in contact with the soil, wherein the damping plates serve both as heat insulators for the construction as well as a support to keep the reinforcement in place.

In a still further embodiment, the proposed method further comprises installing a concrete casting between said one or more damping plates and said electromagnetic pulse screening fabric. Advantageously, this provides protection against corrosion, and permanent mechanical protection of the EMP fabric.

In an exemplary embodiment for protection from very high frequency EMP pulse (of the order of 3GHz), said electromagnetic pulse screening fabric comprises a copper mesh having a rectangular mesh size equal to or less than 0.4mm X 0.4mm.

According one embodiment, said surface is an outer surface of said enclosed construction. In this case, the present invention provides an outdoor installation that is independent of temperature and the negative impacts of atmospheric humidity.

According another embodiment, said surface is an inner surface of said enclosed construction. Advantageously, this indoor installation of the screening fabric can be removed again and used in modular manner.

The present invention is further described hereinafter with reference to illustrated embodiments shown in the accompanying drawings, in which:
FIG 1 is a flowchart illustrating an exemplary installation method for protecting an enclosed construction from an electromagnetic pulse,
FIGS 2A and 2B are schematic diagrams illustrating installation of supporting structures for EMP screening fabric according to one embodiment of the present invention,
FIGS 3A and 3B are schematic diagrams illustrating installation of supporting structures for EMP screening fabric according to an alternate embodiment of the present invention
FIG 4 is a schematic diagram illustrating installation of an EMP screening fabric over the supporting structures, and
FIG 5 is a cross-sectional view of an arrangement for protecting an enclosed construction from an electromagnetic pulse according a preferred embodiment of the present invention.

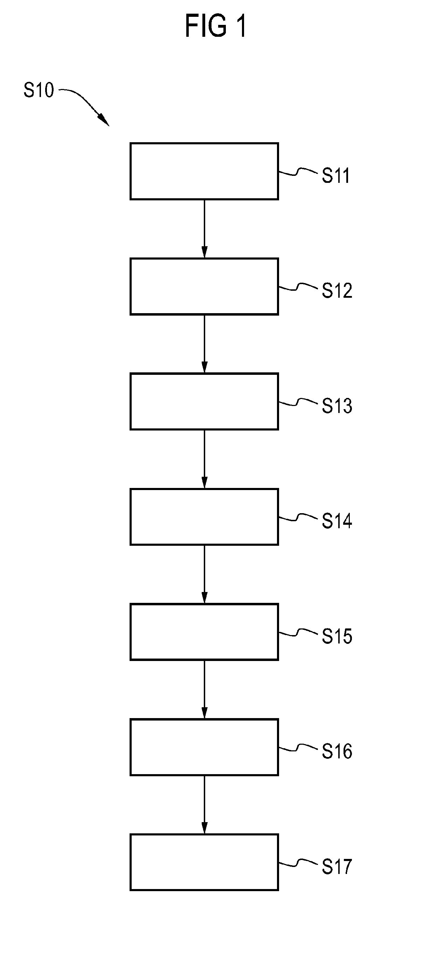

Embodiments of the present invention described below provide a technique to protect an entire enclosed construction from an EMP pulse based on the principle of the "Faraday cage" using an EMP screening fabric made of an electrically conductive material. In accordance with the present invention, electrically insulative supporting or carrier structures are first installed on to a surface of the construction and the EMP screening fabric is then fastened on to the supporting structures. The proposed installation ensures that all electrical connections are closed. Embodiments of the present invention advantageously eliminate the need to use of any embedding materials such as bitumen or plaster on the EMP fabric for support. The illustrated embodiments can be used for both indoor and outdoor installations. Embodiments of the present invention are now described with reference to FIGS 1-5.

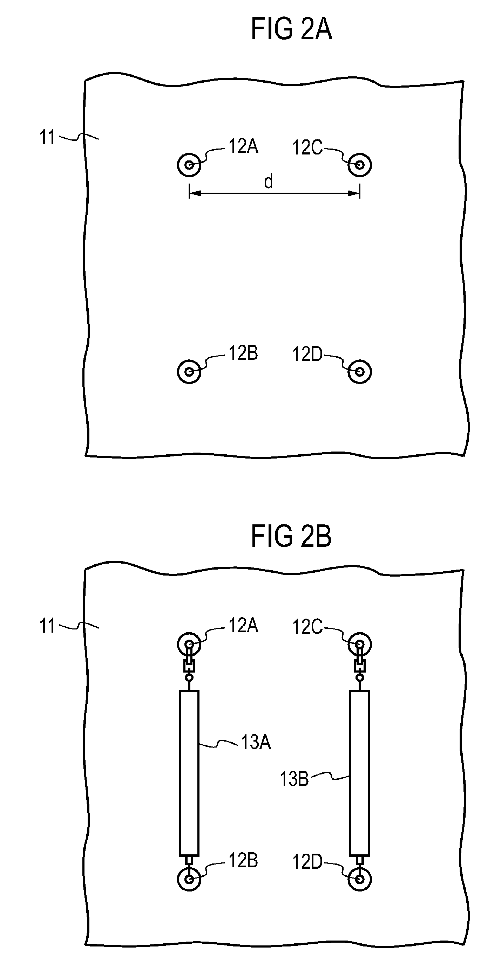

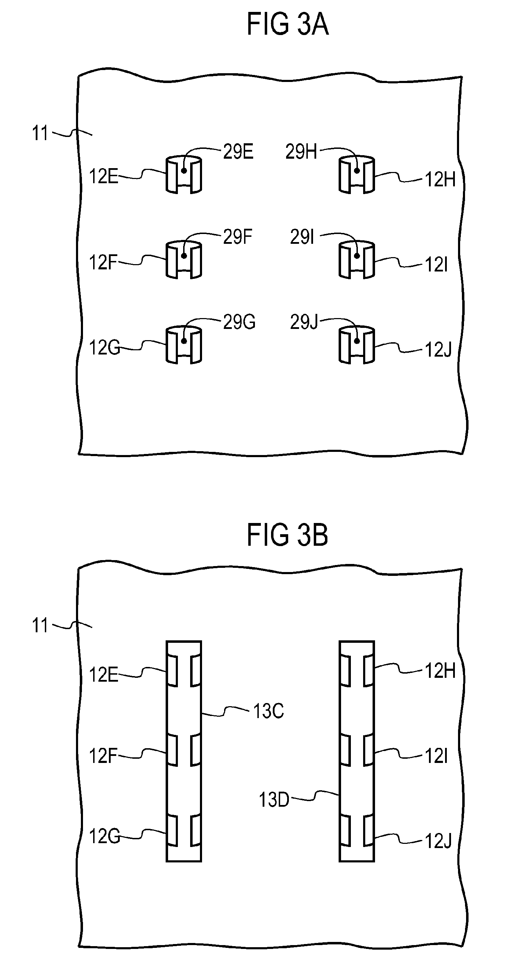

FIG 1 is a flowchart illustrating an exemplary installation method S10 in accordance with the present invention. The method S10 begins at step S11, by installing the supporting structures on a surface of a enclosed construction. The installation may be on an inner surface (i.e., indoor installation) or on an outer surface (i.e., outdoor installation) of the enclosed construction. The supporting structures are electrically insulative. Step S11 may include, firstly, cleaning the surface of the construction, which is typically made of concrete, followed by fixing anchoring structures for holding the supporting structures, and finally fastening the supporting structures to one or more anchoring structures. An exemplary embodiment of a supporting structure installation is illustrated in FIGS 2A and 2B. An alternate embodiment is illustrated in FIGS 3A and 3B.

In the embodiment shown in FIG 2A, the anchoring structures are pegs or dowels 12A, 12B, 12C and 12D, for example, made of stainless steel, which are first bolted on to a surface 11 of an enclosed construction. The surface 11 may be an inner or an outer surface of the enclosed construction. The distance 'd' between the dowels will depend on the width of the screening fabric to be installed (for e.g., if the width of the screening fabric = 1m, then the distance 'd' between the dowels is 1 m). As shown, the dowels are positioned at locations towards the base and top of the surface 11 that is to be screened. Subsequently, as shown in FIG 2B, the supporting structures 13A and 13B are installed between the anchoring structures or dowels. In this example, the supporting structures 13A and 13B are metallic cables, for example, made of steel, and having an electrically insulative outer sheath, for example, made of polyvinyl chloride (PVC). As shown, the cables 13A and 13B are securely anchored at both ends by the anchoring structures or dowels, in a taut configuration.

In the embodiment shown in FIG 3A, the anchoring structures comprise clamps 12E-J. The clamps 12E-J are made from an electrically insulative material, for example PVC, and may be bolted to the surface 11 of the enclosed construction using anchor bolts 29E-J. Subsequently, as shown in FIG 3B, the supporting structures 13C and 13D are secured onto the clamps 12E-J. In this example, the supporting structures 13C and 13D are pipes made of an insulative material, for example PVC.

Referring back to FIG 1, after the installation of the supporting structures the surface at step S11, the EMP screening fabric is installed at step S12, by fastening the EMP screening fabric to one or more of the supporting structures. The EMP screening fabric is a mesh made of an electrically conductive material, for example copper. For shielding against EMP, the mesh size should be sufficiently small with respect to the wavelength of the EMP. In a preferred embodiment, the EMP screening fabric comprises a copper mesh having rectangular mesh size less than or equal to 0.4mm X 0.4mm, which advantageously provides shielding even against very high frequency (i.e., low wavelength) electromagnetic pulse, for example having a frequency of the order of 3GHz.

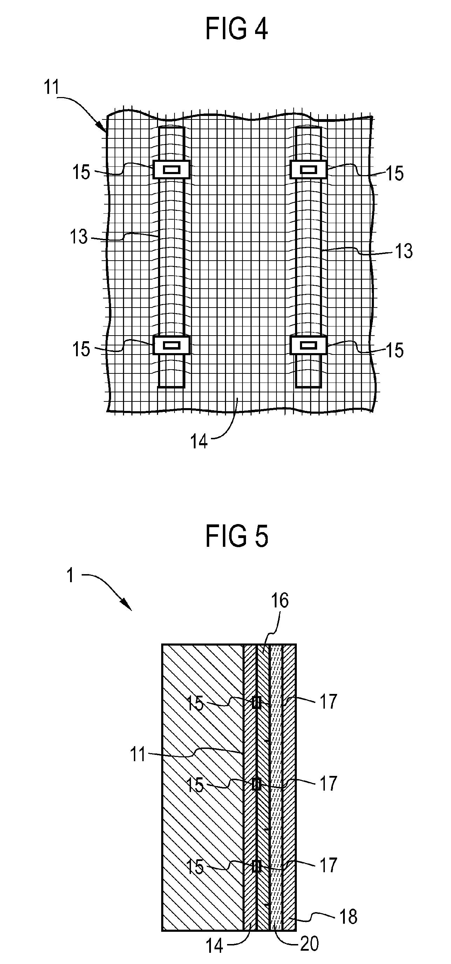

In an exemplary embodiment shown in FIG 4, the EMP screening fabric 14 may be installed by clamping or clipping the fabric 14 to one or more of the already installed supporting structures 13, which in turn may, for example, be of any of the kinds described above. The EMP screening fabric 14 is preferably installed top to bottom, by fixing the fabric 14 at the topmost point, and then directing the fabric downwards. In this example, the EMP screening fabric 14 is fastened to the supporting structures 13 using clamps 15, made of an electrically insulative material such as PVC. The size of the clamps 15 will would depend on the diameter of the supporting structures 13 and the thickness of the EMP screening fabric 14.

It should be noted that one or more pieces of the EMP fabric 14 may be installed to as to form a continuous screening layer around the enclosed construction, effecting a Faraday cage to shield the construction from an external electromagnetic pulse. If more than one pieces of EMP screening fabric is used, the pieces are conductively connected to each other to form the screening layer.

Referring back to FIG 1, next at step S13, a protective fabric may be installed over the EMP screening fabric, to reduce mechanical damages to the EMP screening fabric. Alternately, a double layered EMP screening fabric may be installed. In such a case, step S13 involves installation of a intermediate layer of fabric, for example comprising slings made of stainless steel or steel, synthetic fabric (fiber mesh for rendering and plastering mortar). The installation of the protective layer or the intermediate layer (in case of double layered EMP screening fabric) at step S13 may be done, for example using the clamps or cable binders on clamps that are used for fixing the layer of the EMP fabric installed at step S12. Step S14, which is applicable for double layered EMP screening fabric, accordingly involves installation of the second layer of the EMP screening fabric in a similar manner to the installation of the first layer, i.e., by fastening it to the supporting structures, for example, by means of clamping.

Step S15, involves the installation of a reinforcement structure fixed electrically insulatingly to the EMP screening fabric. This is particularly advantageous for providing mechanical protection in case of installations in contact with the soil. Referring to the exemplary arrangement 1 shown in FIG 5, which is a cross-sectional view of the arrangement 1, the reinforcement structure 16 may be a floor screed or similar steel reinforcement mesh, installed, for example, using PVC cable binders 17 or similar structures attached to clamps 15 that fix the EMP screening fabric 14 (which may be single or double layered as described above).

Referring back to FIG 1, step S16 involves installing one or more damping plates fixed electrically insulatingly to the reinforcement structure. Again, this embodiment is particularly advantageous in cases of installations in contact with the soil, wherein the damping plates serve both as heat insulators for the construction as well as a support to keep the reinforcement in place. Referring to FIG 5, the damping plates 18 are installed using PVC nails that are already fixed to the reinforcement structure 16.

Referring back to FIG 1, in conjunction with FIG 5, step S17 involves installing a concrete casting 20 between the more damping plates 18 and said EMP screening fabric 14. Particularly advantageous for outdoor installations, i.e., for installations on the outer surface of the construction, the concrete casting provides protection against corrosion, and permanent mechanical protection of the EMP fabric. For indoor installations, i.e., for installations on the inner surface of the construction, instead of using the concrete casting, a deck construction made of wooden boards or similar material may be used. This may be used for interiors, containers, facades, etc.

The above-described embodiments of the present invention present several advantages. The illustrated embodiments can be used for both indoor and outdoor installations. Particularly advantageously for outdoor installations, the installation is independent of temperature and the negative impacts of atmospheric humidity. Another advantage of the present invention is that the installation of the EMP screening fabric can be removed again and used in modular manner. Embodiments of the present invention may be advantageously used for EMP protection of civil and particularly industrial constructions, such as constructions housing nuclear reactors and process control technology, where safety from EMP attacks has become quite critical in recent times, specially on account of possible terrorist attacks.

Summarizing, the present invention provides a method and an arrangement for protection for an enclosed construction from an electromagnetic pulse. The proposed method comprises installing a plurality of electrically insulative supporting structures on a surface of said construction. The method then involves installing one or more pieces of an electrically conductive electromagnetic pulse screening fabric by fastening each of said one or more pieces of said fabric to one or more of said supporting structures, said one or more pieces of said fabric being installed so as to form a continuous electrically conductive layer around said construction that is impenetrable for an electromagnetic pulse.

Although the invention has been described with reference to specific embodiments, this description is not meant to be construed in a limiting sense. Various modifications of the disclosed embodiments, as well as alternate embodiments of the invention, will become apparent to persons skilled in the art upon reference to the description of the invention. It is therefore contemplated that such modifications can be made without departing from the spirit or scope of the present invention as defined by the below-mentioned patent claims.

## Claims

1. A method (S10) for protecting an enclosed construction from an electromagnetic pulse, comprising:
- installing (S11) a plurality of electrically insulative supporting structures (13, 13A-B, 13C-D) on a surface (11) of said construction, and
- installing (S12) one or more pieces of an electromagnetic pulse screening fabric (14) made of an electrically conductive material, by fastening each of said one or more pieces of said fabric (14) to one or more of said supporting structures (13, 13A-B, 13C-D), said one or more pieces of said fabric (14) being installed so as to form a continuous electrically conductive layer around said construction that is impenetrable for an electromagnetic pulse.

2. The method (S10) according to claim 1, wherein said installing (S11) of said supporting structures (13, 13A-B, 13C-D) further comprises fixing a plurality of anchoring structures (12A-D, 12E-J) on to said surface (11) of said construction and securely fastening each supporting (13, 13A-B, 13C-D) to one or more of said plurality of anchoring structures (12A-D, 12E-J).

3. The method (S10) according to claim 2, wherein said anchoring structures (12A-D, 12E-J) comprise dowels (12A-D) and said supporting structures (13, 13A-B, 13C-D) comprise metallic cables (13A-B) having respective electrically insulative outer sheaths, wherein installing each of said cables (13A-B) comprises anchoring the ends of that cable (13A-B) tautly between a pair of said dowels (12A-D).

4. The method (S10) according to claim 2, wherein said anchoring structures(12A-D, 12E-J) comprise electrically insulative clamping structures (12E-J) bolted on to said surface (11) and said supporting structures (13, 13A-B, 13C-D) comprise electrically insulative pipes (13C-D), wherein installing each of said pipes (13C-D) comprises clamping that pipe to one or more of said clamping structures (13E-J).

5. The method (S10) according to any of the preceding claims, wherein said fastening of each of said one or more pieces of electromagnetic pulse screening fabric (14) comprises clamping said piece to said one or more supporting structures (13, 13A-B, 13C-D).

6. The method (S10) according to any of the preceding claims, further comprising installing (S13) a layer of protective fabric over said layer of electromagnetic pulse screening fabric (14).

7. The method (S10) according to any of claims 1 to 5, comprising installing two layers of said electrically conductive electromagnetic pulse screening fabric (14) separated by an intermediate electrically insulative layer of fabric and fastened on to said supporting structures (13, 13A-B, 13C-D).

8. The method (S10) according to any the preceding claims, comprising installing (S15) a reinforcement structure (16) fixed electrically insulatingly to said electromagnetic pulse screening fabric (14).

9. The method (S10) according to claim 8, further comprising installing (S16) one or more damping plates (18) fixed electrically insulatingly to said reinforcement structure (16).

10. The method (S10) according to claim 9, further comprising installing (S17) a concrete casting (20) between said one or more damping plates (18) and said electromagnetic pulse screening fabric (14).

11. The method (S10) according to any of the preceding claims, wherein said electromagnetic pulse screening fabric (14) comprises a copper mesh having a rectangular mesh size equal to or less than 0.4mm X 0.4mm.

12. The method (S10) according to any of the preceding claims, wherein said surface (11) is an inner surface or an outer surface of said enclosed construction.

13. An arrangement (1) for protecting an enclosed construction from an electromagnetic pulse, comprising:
- a plurality of electrically insulative supporting structures (13, 13A-B, 13C-D) installed on a surface (11) of said construction, and
- one or more pieces of an electromagnetic pulse screening fabric (14) made of an electrically conductive material, installed by fastening each of said one or more pieces of said fabric (14) to one or more of said supporting structures (13, 13A-B, 13C-D), said one or more pieces of said fabric (14) forming a continuous electrically conductive layer around said construction that is impenetrable for an electromagnetic pulse.

14. The arrangement (1) according to claim 13, further comprising a plurality of anchoring structures (12A-D, 12E-J) fixed on to said surface (11) of said construction, wherein each of said supporting structures (13, 13A-B, 13C-D) is fastened to one or more of said plurality of anchoring structures (12A-D, 12E-J).

15. The arrangement (1) according to any of claims 13 and 14, wherein each of said one or more pieces of electromagnetic pulse screening fabric (14) is clamped to said one or more supporting structures (13) using electrically insulative clamping structures (15).

16. The arrangement (1) according to any of claims 13 to 15, wherein said surface (11) is an outer surface or an inner surface of said enclosed construction.
